# EUROPÄISCHE PATENTSCHRIFT

(11) **EP 3 590 018 B1**
(45) Veröffentlichungstag und Bekanntmachung des Hinweises auf die Patenterteilung: **04.11.2020**
(21) Anmeldenummer: 18711031.7
(22) Anmeldetag: 01.03.2018
(51) Int. Cl.: G05G 1/02, H03K 17/96

(54) **BEDIENELEMENT**
CONTROL ELEMENT
ÉLÉMENT DE COMMANDE

(30) Priorität: 02.03.2017 DE 102017002041
(43) Veröffentlichungstag der Anmeldung: 08.01.2020
(73) Patentinhaber: KOSTAL Automobil Elektrik GmbH & Co. KG, 58513 Lüdenscheid (DE)
(72) Erfinder: BORGMANN, Uwe, 45665 Recklinghausen (DE); BLECKMANN, Michael, 58239 Schwerte-Ergste (DE)
(74) Vertreter: Kerkmann, Detlef
(86) Internationale Anmeldenummer: PCT/EP2018/055070
(87) Internationale Veröffentlichungsnummer: WO 2018/158381

(56) Entgegenhaltungen:
- DE-A1- 10 341 887
- DE-A1-102010 024 776
- DE-A1-102013 212 083
- DE-A1-102014 222 668
- DE-T5-112005 003 197

## Beschreibung

Die Erfindung betrifft ein Bedienelement, insbesondere zur Dach- oder Fensterverstellung in einem Kraftfahrzeug, wobei das Bedienelement eine Oberfläche mit einer eingebrachten Mulde aufweist, und mit einem mit der Oberfläche verbundenen Flächenabschnitt über der Mulde, der die Mulde nur teilweise überdeckt, wobei mindestens ein Sensor in den Flächenabschnitt eingeformt ist oder ganz oder teilweise an der Unterseite des Flächenabschnitts angeordnet oder angeformt ist.

Ein derartiges Bedienelement ist aus der deutschen Offenlegungsschrift DE 10 2010 024 776 A1 bekannt. Zur Erfassung einer Betätigung weist das Bedienelement berührungssensitive Sensoren und Kippschalter auf.
Aus der deutschen Offenlegungsschrift DE 102 12 768 A1 ist ein aus einem harten Kunststoff gefertigtes Betätigungselement in Form eines Kraftfahrzeugtürgriffs, einer Griffmulde oder einer Griffleiste bekannt. In einer Höhlung des Betätigungselementes ist ein Taster angeordnet, der mit dem Daumen einer das Betätigungselement umfassenden Hand betätigbar ist. Dabei ist vorgesehen, dass der Stößel des Tasters unterhalb einer sich bei Daumendruckbeaufschlagung durchbiegbaren Zone der Höhlungswandung angeordnet ist und die durchbiegbare Zone eine zusammen mit dem Griff gespritzte flexible Weichkunststoffzone ist.

Bedienelemente, insbesondere solche für Kraftfahrzeuge, sind in ihrer Ausgestaltung einem stetigen Wandel unterworfen. In zeitgemäß gestalteten Fahrzeugen werden zunehmend einzelne Funktions- oder Formelemente zusammengefasst, Fugen und Höhensprünge werden reduziert und Beleuchtungen und Funktionen sind nicht immer sichtbar. Sensorisches Schalten über Berühr- oder Kraftsensoren bietet die Möglichkeit, den Anforderungen eines modernen Designs gerecht zu werden.

Bei Bedienelementen für Fenster und Schiebedächer erschweren Sicherheitsanforderungen, wie beispielsweise die amerikanische Norm FMVSS 571.118, eine Umsetzung. Bei diesen Bedienelementen darf laut dieser Norm ein unbeabsichtigtes Schließen des Fensters oder des Daches nicht möglich sein. Umgesetzt wird dies üblicherweise durch eine Formgebung, die ein Betätigen mit einem speziellen Testobjekt nicht erlaubt.

Weiterhin sind diese Bedienelemente im Allgemeinen mit einer Betätigungsstufe für den manuellen und einer Betätigungsstufe für den automatischen Fenster-/Dachlauf ausgestattet.

Es stellte sich die Aufgabe, ein Bedienelement für Fenster oder Schiebedächer zu schaffen, das eine geschlossene, spaltfreie Oberfläche aufweist, den Anforderungen der einschlägigen Normen gerecht wird und ein komfortables Öffnen des Fensters oder des Daches ermöglicht.

Diese Aufgabe wird erfindungsgemäß dadurch gelöst, dass der Flächenabschnitt mit der Oberfläche einstückig und spaltfrei verbunden ist, und dass der mindestens eine Sensor eine Verformung des Flächenabschnitts erfasst.

Das Bedienelement ist einer Push/Pull-Taste nachempfunden und besteht aus einer geschlossenen Oberfläche. Im Betätigungsbereich ist die Struktur flexibel ausgelegt, so dass bei Betätigung eine Verformung der Oberfläche stattfindet. Durch das Messen der Verformung können die Kraft und die Richtung einer Betätigung erfasst werden. In Verbindung mit einem mit variabler Geschwindigkeit verfahrenden Verstellelement kann dadurch nicht nur die Richtung, sondern auch die Geschwindigkeit des Verstellelements durch den Nutzer gesteuert werden.

Im Folgenden soll die Erfindung anhand der Zeichnung dargestellt und näher erläutert werden. Es zeigen
- Figur 1: eine Draufsicht auf ein Bedienelement,
- Figur 2: das Bedienelement in einer Schnittansicht,
- Figuren 3 bis 6: jeweils das Bedienelement in einer Schnittansicht mit verschiedenen Ausführungen eines Sensors.

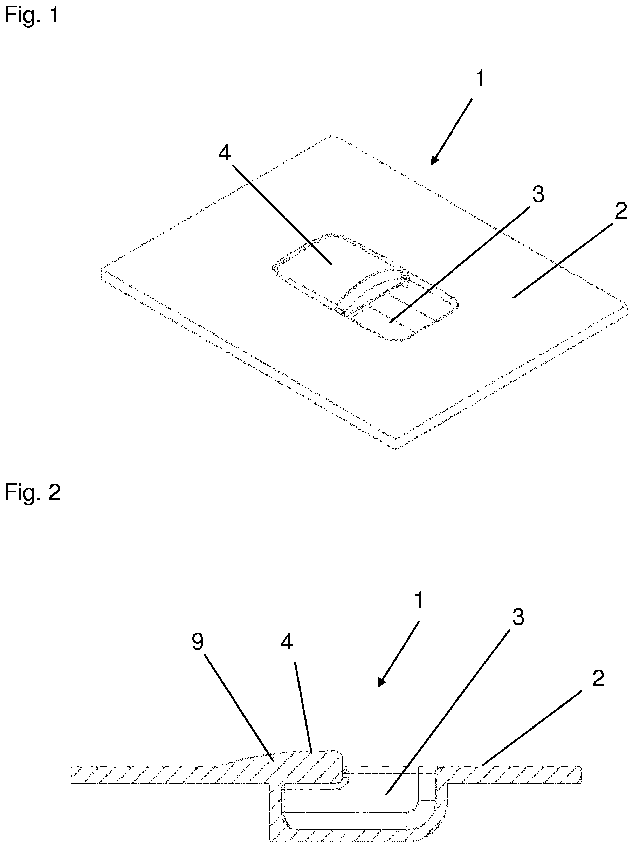

Die Figur 1 stellt ein erfindungsgemäß ausgeführtes Bedienelement in einer Draufsicht dar. Das Bedienelement 1 weist eine äußerlich strukturiert gestaltete Oberfläche 2 auf. Die in der Figur 1 abgebildete Oberfläche 2 kann insbesondere ein Ausschnitt aus einer größeren zusammenhängenden Bedien- oder Innenraumfläche eines Kraftfahrzeugs sein.

Die Strukturierung besteht darin, dass in die Oberfläche 2 einstückig eine Vertiefung eingeformt ist, die nachfolgend als Mulde 3 bezeichnet wird. Nur ein Teilstück, vorzugsweise zwischen einem Viertel und der Hälfte der Gesamtfläche der Muldenöffnung wird von einem Flächenabschnitt 4 überdeckt, der einstückig mit der übrigen Oberfläche 2 verbunden ist.

Wie die Schnittansicht der Figur 2 verdeutlicht, bildet die Oberfläche 2 einen materialverstärkten Abschnitt 9 aus, von dem ein Teilstück als Flächenabschnitt 4 über einen Rand der Mulde 3 übersteht. Dieser Flächenabschnitt 4 bildet den Betätigungsbereich des Bedienelements 1 aus.

Wie die Figur 1 zeigt, sind bis auf den sich in Richtung der Muldenöffnung erstreckenden Rand des Flächenabschnitt 4 alle weiteren Ränder des Flächenabschnitts 4 spaltfrei mit der Oberfläche 2 verbunden.

Hierdurch ergibt sich, dass der Flächenabschnitt 4 nicht frei beweglich und insbesondere nicht um eine Kante verschwenkbar angeordnet ist. Allerdings ist der Flächenabschnitt 4 durch Formgebung und Materialstärke so ausgebildet, dass er durch eine Krafteinwirkung von der Oberseite oder der muldenseitigen Unterseite her in einem gewissen Umfang verformbar ist.

Die zur Betätigung des Bedienelements 1 erforderlichen Kräfte können durch die Festlegung der Wandstärke im Bereich des Flächenabschnitts 4 beeinflusst werden. Anders als hier dargestellt können die Oberfläche 2 einerseits und der Flächenabschnitt 4 andererseits auch aus unterschiedlichen Kunststoffmaterialien gefertigt werden, die etwa durch ein Mehrkomponentenspritzgießen einstückig miteinander verbunden werden.

Um eine Betätigung des Flächenabschnitt 4 von dessen Unterseite her zu ermöglichen, ist es zweckmäßig, wenn die Breite 7 des sich zwischen dem Muldenboden 6 und dem Flächenabschnitt 4 ergebenden Zwischenraum ausreichend groß für das Eingreifen einer Fingerkuppe dimensioniert ist.

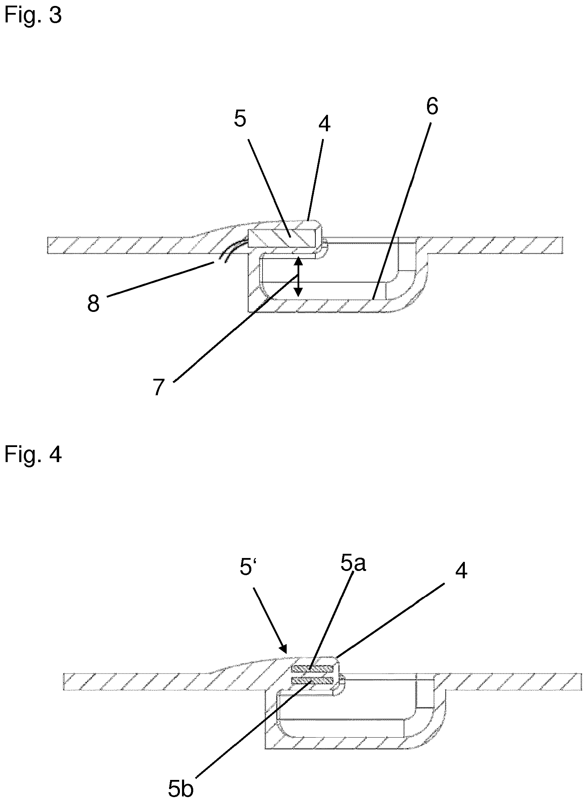

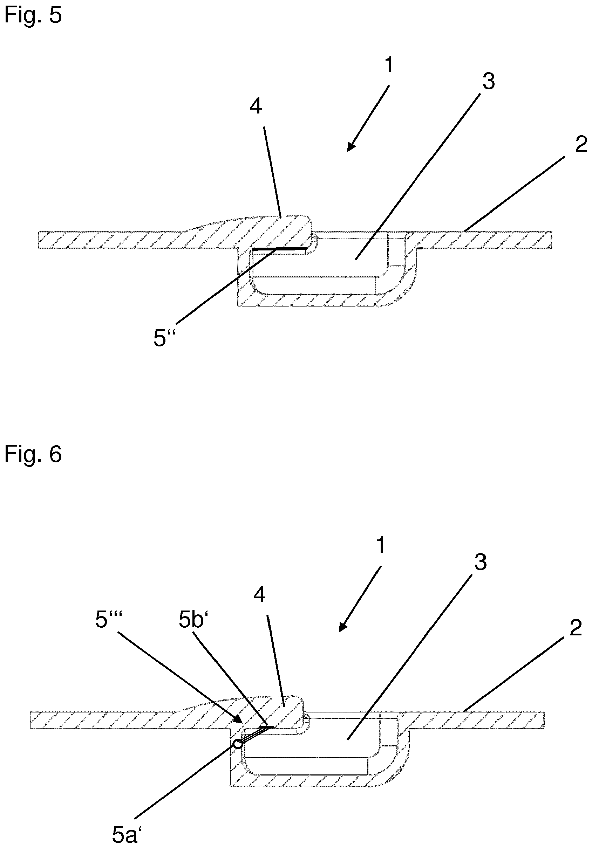

Um eine Krafteinwirkung als eine Betätigung des Bedienelements 1 zu registrieren, ist ein Sensor 5, 5', 5", 5'" vorgesehen, der Verformungen des Flächenabschnitts 4 erfasst. Solche Sensoren 5, 5', 5", 5'" können nach unterschiedlichen physikalischen Messprinzipien funktionieren. Die Figuren 3 und 5 zeigen jeweils eine einteilige Ausführung eines Sensors 5, 5" und die Figuren 4 und 6 jeweils eine Ausführung eines Sensors 5', 5", der aus mehreren Sensorkomponenten 5a, 5b; 5a', 5b' besteht.

Der einteilige Sensor 5 in der Figur 3 kann beispielsweise ein Dehnungsmessstreifen sein, der in den Flächenabschnitt 4 eingeformt ist, also etwa bei der Herstellung des Bedienelements 1 in einem Spritzgießwerkzeug umspritzt wurde. Zuleitungen 8 des Sensors 5 sind an der Unterseite des Bedienelements 1 aus dem Kunststoffmaterial herausgeführt, so dass eine zum Sensor 5 gehörende, hier nicht dargestellte Auswerteelektronik, außerhalb des Kunststoffkörpers angeordnet sein kann.

Ein beispielsweise als Dehnungsmessstreifen ausgeführter einteiliger Sensor 5" kann auch an der Unterseite des Flächenabschnitts 4 angeformt oder angeordnet sein. Diese Ausführung ist in der Figur 5 skizziert und erspart das Umspritzen des Sensors 5", der hier beispielsweise einfach durch Kleben an der Unterseite des Flächenabschnitts 4 befestigt ist.

Manche Messprinzipien erfordern einen mehrteiligen Sensoraufbau, wie er jeweils in den Figuren 4 und 6 skizziert ist. Die Sensoren 5' und 5'" bestehen hier beispielhaft jeweils aus zwei Sensorkomponenten 5a, 5b; 5a', 5b'.

Gemäß der Figur 4 sind beide Sensorkomponenten 5a, 5b in den Flächenabschnitt 4 eingespritzt. Der Sensor 5' kann beispielsweise einen optischen Sensor ausbilden; in diesem Fall bestehen die Sensorkomponenten 5a, 5b aus einem Lichtsender und einem Lichtempfänger. Soll ein induktiver Sensor verwendet werden, so bestehen die Sensorkomponenten 5a, 5b etwa aus einer Induktionsspule und einem Metallkörper, deren Verschiebungen gegeneinander bei einer Verformung des Flächenabschnitts 4 erfasst werden können.

Die Figur 6 zeigt einen weiteren aus zwei Sensorkomponenten 5a', 5b' bestehenden zweiteiligen Sensor 5'", der hier speziell einen optischen Sensor, bestehend aus einem Lichtsender 5a' und einem Lichtempfänger 5b' darstellt. Im Unterschied zu der in der Figur 4 dargestellten Ausführung sind die Sensorkomponenten 5a', 5b' hier nicht vollständig in den Flächenabschnitt 4 eingespritzt. Statt dessen ist der Lichtempfänger 5b' an der Unterseite des Flächenabschnitts 4 angeordnet und zwar vorzugsweise derart, dass die Außenfläche eines zum Lichtempfänger 5b' gehörenden Lichteinfallsfensters plan mit Unterseite des Flächenabschnitts 4 ausgerichtet ist. Der Lichtempfänger 5b' wird durch einen Lichtsender 5a' beleuchtet, der in einen Wandabschnitt der Mulde 3 an- oder eingeformt ist, so dass die Oberfläche des Lichtsenders 5a' bis zur Oberfläche des Wandabschnitts reicht. Die Menge des vom Lichtsender 5a' auf den Lichtempfänger 5b' fallenden Lichts verändert sich, wenn der Flächenabschnitt 4 deformiert wird, so dass der Lichtempfänger 5b' Verformungen des Flächenabschnitts 4 quantitativ erfassen kann. Durch beispielsweise einen ortsauflösend messenden Lichtempfänger 5b' können darüber hinaus auch Druck- und Zugeinwirkungen auf den Flächenabschnitt 4 unterschieden werden.

Sensoren 5, 5', 5", 5'", die geeignet sind Deformationen des Flächenabschnitts 4 zu registrieren, können im Allgemeinen sowohl Druck- wie auch Zugbelastungen erfassen, die sich durch Krafteinwirkungen auf die Oberseite beziehungsweise auf die Unterseite des Flächenabschnitts 4 ergeben. Dabei ist es vorteilhaft, wenn der Sensor 5, 5', 5", 5"', beziehungsweise die an diesen angekoppelte Auswerteelektronik geeignet ist, solche Betätigungen nicht nur zu erfassen, sondern auch in ihren Richtungen zu unterscheiden, um entsprechend mehrere Betätigungsfunktionen auslösen zu können.

Für viele Anwendungen ist es vorteilhaft, wenn der Sensor 5, 5', 5", 5"', auch die Stärke der Verformung des Flächenabschnitts 4 und damit die Kraft der Betätigung quantitativ erfassen kann. Hierdurch kann beispielsweise die Verstellgeschwindigkeit eines Fahrzeugfensters oder Fahrzeugdaches abhängig von der Betätigungskraft des Bedienelements 1 variiert werden. Darüber hinaus kann auch der Übergang von einer manuellen zu einer automatischen Verstellung motorisch betätigter Fahrzeugfenster oder -dächer als abhängig von der Stärke der auf den Flächenabschnitt 4 einwirkenden Betätigungskraft ausgelegt werden.

### Bezugszeichen

- 1: Bedienelement
- 2: Oberfläche
- 3: Mulde
- 4: Flächenabschnitt
- 5, 5', 5", 5'": Sensor
- 5a, 5b, 5a', 5b': Sensorkomponenten
- 6: Muldenboden
- 7: Breite
- 8: Zuleitungen
- 9: materialverstärkter Abschnitt

## Patentansprüche

1. Bedienelement, insbesondere zur Dach- oder Fensterverstellung in einem Kraftfahrzeug,
wobei das Bedienelement (1) eine Oberfläche mit einer eingebrachten Mulde (3) aufweist,
und mit einem mit der Oberfläche (2) verbundenen Flächenabschnitt (4) über der Mulde (3), der die Mulde (3) nur teilweise überdeckt,
wobei mindestens ein Sensor (5, 5', 5", 5"') in den Flächenabschnitt (4) eingeformt ist oder ganz oder teilweise an der Unterseite des Flächenabschnitts (4) angeordnet oder angeformt ist,
**dadurch gekennzeichnet,**
**dass** der Flächenabschnitt (4) mit der Oberfläche (2) einstückig und spaltfrei verbunden ist, und
**dass** der mindestens eine Sensor (5, 5', 5", 5"') eine Verformung des Flächenabschnitts (4) erfasst.

2. Bedienelement nach Anspruch 1, **dadurch gekennzeichnet, dass** alle Außenflächen des Bedienelements (1) aus einem einzigen Kunststoffmaterial gebildet sind.

3. Bedienelement nach Anspruch 1, **dadurch gekennzeichnet, dass** der Sensor (5, 5', 5", 5'") ein kontaktloser Sensor ist.

4. Bedienelement nach Anspruch 1, **dadurch gekennzeichnet, dass** der Sensor (5, 5', 5", 5'") Druck- und Zugeinwirkungen auf den Flächenabschnitt (4) erkennen und unterscheiden kann.

5. Bedienelement nach Anspruch 1, **dadurch gekennzeichnet, dass** der Sensor (5, 5', 5", 5"') die Stärke der Verformung des Flächenabschnitts (4) zur Ermittlung einer Betätigungskraft quantitativ erfasst.

6. Bedienelement nach Anspruch 1, **dadurch gekennzeichnet, dass** das Bedienelement (1) zur Steuerung der Bewegung motorisch verstellbarer Fenster oder Schiebedächer vorgesehen ist.

## Claims

1. Control element, in particular for adjusting the roof or windows in a motor vehicle wherein the operating element (1) has a surface with an inserted recess (3),
and with a surface section (4) connected to the surface (2) above the trough (3), which only partially covers the trough (3),
wherein at least one sensor (5, 5', 5", 5'") is moulded into the surface portion (4) or is arranged or moulded on in whole or in part on the underside of the surface portion (4),
**characterized by this,**
in that the surface section (4) is connected to the surface (2) in one piece and without a gap, and
in that the at least one sensor (5, 5', 5", 5"') detects a deformation of the surface section (4).

2. Control element according to claim 1, **characterized in that** all outer surfaces of the control element (1) are formed from a single plastic material.

3. Control element according to claim 1, **characterized in that** the sensor (5, 5', 5", 5"') is a contactless sensor.

4. Control element according to claim 1, **characterized in that** the sensor (5, 5', 5", 5"') can detect and distinguish between pressure and tensile effects on the surface portion (4).

5. Control element according to claim 1, **characterized in that** the sensor (5, 5', 5", 5"') quantitatively detects the amount of deformation of the surface portion (4) to determine an actuating force.

6. Operating element according to claim 1, **characterized in that** the operating element (1) is provided for controlling the movement of motor-driven adjustable windows or sliding roofs.

## Revendications

1. Elément de commande, en particulier pour le réglage de toit ou de vitre dans un véhicule automobile,
sachant que l'élément de commande (1) présente une surface dans laquelle est pratiquée une cavité (3),
et une section plate (4), reliée à la surface (2), au-dessus de la cavité (3), laquelle ne recouvre la cavité (3) que partiellement,
sachant qu'au moins un capteur (5, 5', 5", 5"') est formé dans la section plate (4) ou est disposé ou formé entièrement ou partiellement sur la face inférieure de la section plate (4),
**caractérisé en ce que**,
la section plate (4) est reliée, d'une pièce et exempte de fente, à la surface (2), et
que l'au moins un capteur (5, 5', 5", 5'") saisit une déformation de la section plate (4).

2. Élément de commande selon la revendication 1, **caractérisé en ce que** toutes les faces extérieures de l'élément de commande (1) sont en un un matériau synthétique unique.

3. Élément de commande selon la revendication 1, **caractérisé en ce que** le capteur (5, 5', 5", 5'") est un capteur sans contact.

4. Élément de commande selon la revendication 1, **caractérisé en ce que** le capteur (5, 5', 5", 5"') peut reconnaitre et différencier les effets de pression et de traction exercés sur la section plate (4).

5. Élément de commande selon la revendication 1, **caractérisé en ce que** le capteur (5, 5', 5", 5"') capte l'importance de la déformation de la section plate (4) pour la détermination quantitative d'une force d'actionnement.

6. Élément de commande selon la revendication 1, **caractérisé en ce que** l'élément de commande (1) est prévu pour la commande du déplacement de vitres ou de toits ouvrants réglables de manière motorisée.
